# EUROPEAN PATENT APPLICATION

(11) **EP 0 814 497 A2**
(43) Date of publication of application: **29.12.1997**
(21) Application number: 97304224.5
(22) Date of filing: 17.06.1997
(51) Int. Cl.: H01L 21/318, H01L 21/30, H01L 21/22

(54) **Device structure with layer for facilitating passivation of surface states**

(30) Priority: 17.06.1996 US 664484
(71) Applicant: SIEMENS AKTIENGESELLSCHAFT, 80333 München (DE); KABUSHIKI KAISHA TOSHIBA, Kawasaki-shi, Kanagawa-ken 210 (JP); International Business Machines Corporation, Armonk, N.Y. 10504 (US)
(72) Inventor: Alsmeier, Johann, Wappingers Falls, NY 12590 (US); Cote, Donna R., Poughquag, NY 12570 (US); Loh, Stephen K., Fishkill, NY 12524 (US); Parries, Paul C., Wappingers Falls, NY 12590 (US); Gifford, George G., Poughkeepsie, NY 12603 (US); Prein, Frank, Glen Allen, VA 23060 (US); Levy, Max G., Essex Junction, VT 05452 (US); Sugiura, Soichi c/o Kabushiki Kaisha Toshiba, Minato-ku, Tokyo (JP)
(74) Representative: Muir, Ian R.

(57) **Abstract**

A process for fabricating a device including the step of forming a structure for facilitating the passivation of surface states is disclosed. The structure comprises a hydrogen-rich (H-R) silicon nitride layer formed as part of the device structure. The H-R layer, which is formed by plasma-enhanced chemical vapor deposition, comprises hydrogen in an amount greater than that of conventional PLCVD nitride layers.

## Description

The invention generally relates to devices and device fabrication and, in particular, to devices having a layer for facilitating passivation of surface states and a process for fabricating such devices.

In device fabrication, insulating, semiconducting, and conducting layers are produced and patterned on a substrate to form device structures, such as transistors, capacitors, or resistors. These device structures are then interconnected to achieve a desired electrical function. The production and patterning of the various device layers are achieved using conventional fabrication techniques such as, for example, oxidation, implantation, deposition, epitaxial growth of silicon, lithography and etching. Such techniques are described in S.M. Sze, "VLSI Technology", 2nd ed., New York, McGraw-Hill, 1988.

Conventional fabrication techniques induce various forms of defect or damage to the layers within the device. For example, damage to chemical bonds at the semiconductor interfaces creates dangling bonds known as surface or interface states. Surface states promote recombination of electron-hole pairs. Recombination is a phenomenon whereby electron-hole pairs are annihilated or destroyed. Recombination, particularly if it occurs at critical device interfaces such as isolation perimeters and gate oxides, results in leakage current. Leakage current alters the gate threshold voltage, data retention, and standby power consumption of devices. Thus, the presence of interface states adversely affects device functions.

Surface states are repaired by providing hydrogen atoms to passivate the dangling bonds. Conventionally, relatively high temperature anneals, typically about 400 to 600 °C, in hydrogen-containing ambients have been employed to supply hydrogen to passivate the dangling bonds. The passivation anneal is usually performed late in the device fabrication processing sequence, such as after the formation of the various layers, including the metallization or interconnection layer. This reduces the number of passivation anneals required to repair the dangling bonds created during previous fabrication processes. Reduction in the number of passivation anneals reduces process costs.

However, current interconnection schemes and device structures tend to inhibit the ability of the hydrogen atoms to reach the recombination sites to passivate the dangling bonds. As such, the effectiveness and efficiency of the passivation anneal is reduced. For instance, silicon nitride deposited by low pressure chemical vapor deposition (LPCVD), which serves as a mobile ion and transition metal diffusion barrier, blocks the diffusion of hydrogen. This LPCVD silicon nitride film prevents hydrogen from penetrating to the layers below to passivate the surface states existing in those layers. In tungsten stud structures, the tungsten quenches the hydrogen, producing a similar effect as the silicon nitride layer. The efficiency of passivation anneals is further reduced since nitrogen gas is often used to dilute the hydrogen (forming gas) in order to decrease the inherent danger associated with the explosive nature of hydrogen.

From the above discussion, it is apparent that there is a need to effectively passivate the surface states caused by device fabrication techniques.

The invention is generally related to device fabrication. As known in the art, conventional device fabrication techniques damage chemical bonds, creating surface states at semiconductor interfaces. These surface states are repaired or passivated by supplying hydrogen atoms during a hydrogen anneal. However, current device structures tend to block hydrogen from reaching and passivating the surface states.

According to the invention, there is provided a process for fabricating a semi-conductor device comprising the steps of:
forming a layer of hydrogen-rich silicon nitride in the device; and
heating the device to a temperature above the temperature used for depositing the hydrogen rich silicon nitride layer, wherein the heating step causes hydrogen atoms to diffuse throughout the device for passivating surface states within the device.

The process thus includes the step of fabricating a device structure for facilitating the passivation of surface states comprising a hydrogen-rich (H-R) silicon nitride layer. In one embodiment, the H-R layer is formed by plasma-enhanced chemical vapor deposition (PECVD). Typically, hydrogen content of the H-R layer is greater than about 5 and less than or equal to about 39 atomic weight percent. It is believed that the increased hydrogen content in the H-R layer serves as a source of hydrogen for passivating the surface states. At temperatures above the temperature used in forming the H-R layer, hydrogen from the H-R layer diffuses throughout the device, reaching and passivating the surface states.

For a better understanding of the present invention, and to show how it may be brought into effect, reference will now be made, by way of example, to the accompanying drawings, in which:
FIG. 1 depicts a simplified device structure of a known transistor;
FIG. 2 depicts a simplified device structure of a transistor with a passivation layer;
FIG. 3 depicts a simplified device structure of a transistor with a passivation layer as part of a composite gate;
FIG. 4 is a graph comparing leakage current of devices having a conventional nitride film with devices having a hydrogen-rich (H-R) nitride film; and
FIG. 5 is a graph comparing the characterization of conventional low pressure chemical vapor deposited nitride film and H-R nitride films.

The present invention relates to the passivation of surface states created during device fabrication. For purposes of illustration, the invention will be described in the context of MOS devices. However, the invention is significantly broader and extends to the fabrication of devices in general, such as bipolar devices, BiCMOS, thin film transistors, heterojunction devices, and the like.

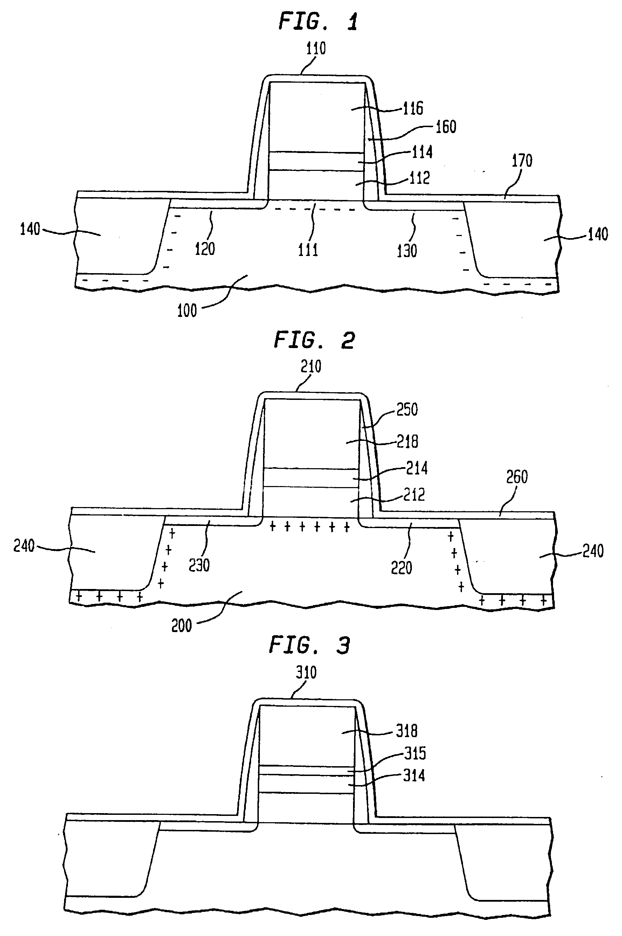

In Fig. 1, a MOS device structure 100, such as those implemented in a dynamic random access memory (DRAM) cell employing trench capacitor, is shown. Illustratively, the structure includes a gate region 110, source region 120, drain region 130, and shallow trench isolation (STI) regions 140. The gate region typically comprises a polycrystalline (poly) layer 112 formed over a gate oxide 111. In some applications, a layer of silicide 114 is used to form a composite gate stack. Various silicides, including molybdenum (MoSiₓ), tantalum (TaSiₓ), tungsten (WSiₓ), titanium silicide (TiSiₓ) or cobalt silicide (CoSiₓ), are used to form layer 114. Alternatively, aluminum or refractory metals, such as tungsten and molybdenum, are used alone or in combination with silicides or poly. Composite gates are desirable as their use reduces the sheet resistance of the gate region, thereby decreasing the R-C delay of signals that are routed along it. A nitride cap 116 is deposited over the gate by low pressure chemical vapor deposition (LPCVD). The cap serves as an etch stop for subsequent process steps. A spacer 160 is deposited over the gate to define the underlap diffusion of the source and drain regions into the gate region, which reduces overlap capacitance. After spacer formation, a nitride layer 170 is deposited on the side of the gate and over the source, drain, and STI regions to provide a mobile ion barrier and also to serve as an etch stop. A dielectric layer (not shown) is formed over the device structure to provide insulation between the conducting layers (except where contact is desired) or to act as a protective layer to insulate the device structure from impurities, moisture, and scratches. The dielectric layer, for example, includes phosphorus-doped silicon dioxide such as phosphosilicate glass (PSG) or borophosphosilicate glass (BPSG).

Of course, the device structure, as described in Fig. 1, has been simplified for purposes of illustration. For example, the actual device structure used in a DRAM cell includes other regions, such as contacts, local interconnects, and capacitors. The formation of the various regions of the device structure is well-known and described in, for example, Kenney et al., A. Buried Plate Trench Cell For a 64M DRAM, VLSI Tech. Dig. (1992).

Surface states created during the fabrication of the various layers of the device structure are depicted by "-" signs. Typically, as shown, the surface states are located at the gate oxide and STI perimeters. These surfaces states need to be passivated. Typically, a hydrogen anneal is employed to passivate the surface states. During the anneal, hydrogen atoms from the ambient atmosphere pass through the gate to the bulk of the structure. However, most current device structures are capped with a LPCVD silicon nitride layer. As discussed above, the nitride layer prevents hydrogen atoms from passing through it to passivate the surface states.

To overcome the problems created by the use of conventional LPCVD nitride layers, a passivation structure is provided to facilitate the repair of surface states created during fabrication. This passivation structure comprises a hydrogen-rich (H- R) silicon nitride layer incorporated into the device. As known in the art, a conventional LPCVD silicon nitride layer comprises about 3 - 5% hydrogen atoms (all compositional percentages in this disclosure are by atomic %). See Habraken et al., Silicon Nitride and Oxynitride Films, Mat. Sci. and Eng., R12 No. 3 (July 1994) and Chow et al., Hydrogen Content of a Variety of Plasma-Deposited Silicon Nitrides, J. Appl. Phys., Vol. 53, No. 8 (August 1982).

"Hydrogen-rich," as used herein, refers to a percentage of hydrogen greater than that used in conventional LPCVD silicon nitride layers. Experiments have shown that the use of a H-R silicon nitride layer decreases junction leakage currents, indicating successful passivation of surface states.

The exact mechanism of how the H-R silicon nitride layer facilitates the passivation of surface states is not known. However, it is believed that H-R nitride layer acts either as a source of hydrogen atoms or as a structure which allows hydrogen to pass through, or a combination of both. Logically, the increased percentage of hydrogen increases the amount of hydrogen atoms in the H-R silicon nitride layer, thereby creating a source from which hydrogen atoms diffuse to passivate the surface states. Furthermore, as the percentage of hydrogen increases, the density of the nitride layer decreases. The decrease in density allows hydrogen atoms to sufficiently penetrate the nitride layer and into the device structure for surface state passivation.

Fig. 2 shows a simplified device structure 200 used, for example, in a DRAM cell having a H-R silicon layer. As shown, the H-R silicon nitride layer is incorporated into the device structure as a barrier or liner layer 260 at the device interconnection interface. Device structure 200 comprises a gate 210, a drain 220, a source 230, and STI regions 240. Gate 210 includes a poly layer 212, silicide layer 214 such as WSiₓ, and a silicon nitride cap layer 218. Also, the device structure includes spacer layer 250. The drain, source, gate, STI regions, and spacer are formed using conventional techniques.

Next, the H-R layer 260 is formed on the device structure. Formation of the H-R layer is achieved using known plasma enhanced chemical vapor deposition (PECVD) techniques. Such PECVD techniques are described in Gupta et al., The Preparation, Properties and Application of Silicon Nitride Thin Films Deposited By Plasma-Enhanced Chemical Vapor Deposition, Thin Solid Films, 204 (1991).

The temperature at which PECVD is performed is typically between about 300-500°C. Electron-Cyclotron-Resonance Chemical Vapor Deposition (ECRCVD) techniques are also useful for forming the H-R layer. ECRCVD Techniques are described in Kotecki et al., Hydrogen Incorporated In Silicon Nitride Films Deposited By Remote Electron-Cyclotron-Resonance Chemical Vapor Deposition, J. Appl. Phys. 77(3) (Feb. 1, 1995).

The H-R layer comprises a percentage of hydrogen greater than conventional LPCVD silicon nitride. In one embodiment, the percentage of hydrogen is greater than about 5% and less than or equal to about 39%. Percentages of hydrogen exceeding about 39% typically degrade the properties of the silicon nitride film, such as its ability to act as a barrier. Preferably, the percentage of hydrogen is between about 10 - 35%, more preferably between about 10 - 25%, even more preferably about 12 - 25%, and most preferably 15 - 20%.

As previously discussed, PECVD of the H-R layer is typically performed at a temperature between about 300-500°C. Forming the H-R layer at such a relatively low temperature is advantageous. For example, hydrogen atoms from the H-R layer diffuse throughout the device structure during subsequent processes which are performed at a temperature higher than the PECVD temperature. The subsequent higher temperature processes, in some instances, are sufficient to passivate the surface states without the need for a passivation anneal. The passivated surface states are depicted with "+" signs.

A passivation anneal may be employed to passivate the surface states. Typically, conventional passivation anneals are performed at a temperature of about 400°C for about 30-60 minutes in a hydrogen or hydrogen/nitrogen (forming gas) ambient. However, the use of an H-R layer provides an insitu source of hydrogen, thus reducing or eliminating the need for hydrogen containing anneals to effectively passivate the surface states.

Referring to Fig. 3, an H-R layer 315 is formed as part of the gate structure to passivate the surface states. As shown, the H-R layer 315 is formed between the silicide layer 314 and silicon nitride cap layer 318 of the composite gate 310. H-R layer 315 can be used alone or in conjunction with the H-R layer 260 as described in Fig. 2. Additional H-R layer or layers may be formed within the device to enhance the passivation of surface states.

In applications where the H-R silicon nitride layer is deposited over a tungsten layer, such as a tungsten stud structure or a tungsten silicide composite gate, an adhesion promoting layer may be required. The adhesion promoting layer may be necessary because nitrides generally do not adhere well to tungsten. To improve adhesion between tungsten and nitrides, a thin silicon layer is formed over the tungsten prior to the deposition of the H-R layer.

### EXAMPLES

### Example 1

An experiment was conducted to compare leakage currents of devices incorporating the H-R silicon nitride layer against those with conventional silicon nitride layers. Eight lots (samples A-H) with devices fabricated thereon were prepared. The eight lots were processed in 2 different ways. Lots A-D comprise device structures fabricated with a conventional LPCVD silicon nitride layer to serve as a barrier or liner layer at the device interconnection interface. The device structures in lots A-D are similar to those described in Fig. 1. The conventional LPCVD silicon nitride film was deposited by reacting ammonia (NH₃) with dichlorosilane (SiCl₂H₂) in a furnace at about 720°C and 200 mTorr. The ratio of the NH₃ to SiCl₂H₂ is about 10:1. As for Lots E-H, the LPCVD nitride layer is replaced with an H-R silicon nitride layer, such as one described in Fig. 2. The H-R layer is deposited by PECVD in a reactor at about 480°C, 5.75 Torr, and 340 Watts. The process parameters for the reactants are as follows: about 3000 sccm of 2% silane (SiH₄) in nitrogen (N₂), about 1060 sccm of N2, and about 15 sccm of NH₃.

Leakage currents of samples from the two sets of lots were tested using a standard junction leakage test as described in SZE, Physics of Semiconductor Devices, Wiley (1969).

Referring to Fig. 3, the STI bounded junction leakage current test of each lot is shown on an arbitrary scale. Lots A-D represent wafers with LPCVD nitride layer, and lots E-H represent the wafers with PECVD H-R nitride layer. Clearly, the samples with a conventional LPCVD nitride layer show substantially more leakage current than those with the PECVD H-R silicon nitride layer.

### Example 2

In another experiment, the characterization of PECVD H-R nitride films (samples A-C) was compared against that of an LPCVD nitride film. Sample A is a standard silicon nitride deposited by PECVD in a Novellus Concept-1 System. Sample B is a low SiH/UV PECVD nitride film deposited in a Novellus Concept-1 System. Both samples A and B were formed under similar conditions recommended by Novellus as described in "Users guide to 200mm PECVD processing for the Novellus Concept One-200mm Dielectric System" (published by Novellus Systems, Inc., of San Jose, CA, 1992).

Sample C is an H-R silicon nitride film deposited by PECVD in an AME 5000 system from Applied Materials of Santa Clara, CA under similar conditions as the PECVD Film Lots (E-H) of Example 1. Sample D is a LPCVD nitride film deposited by LPCVD under similar conditions as the LPCVD film (Lots A-D) of Example 1.

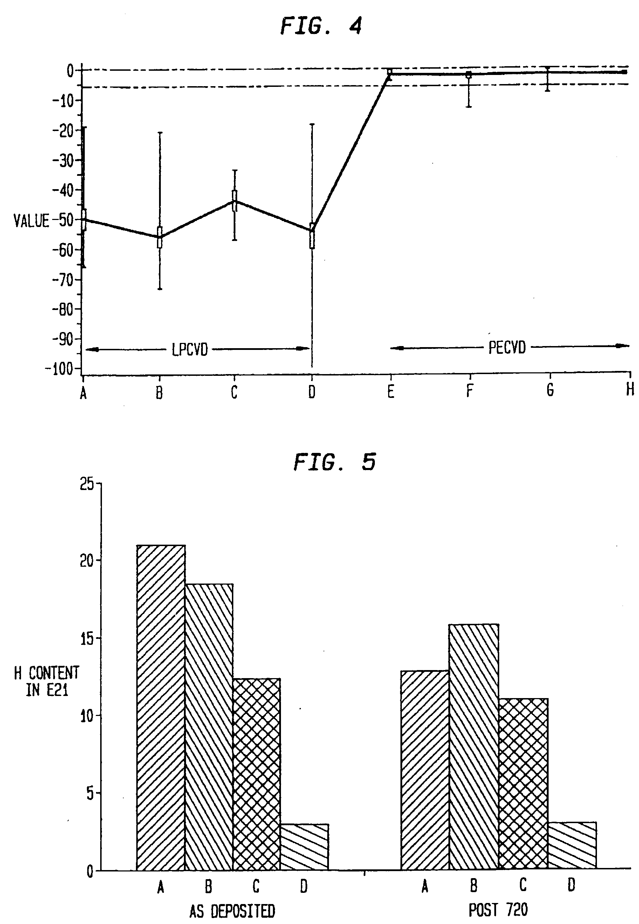

After formation of the film, the samples were heated to 720°C. Referring to Fig. 4, the hydrogen content of the samples were measured after the samples were heated to 720°C. From Fig. 4, the hydrogen content of the PECVD H-R films (sample A-C) decreased after being heated to 720°C while the LPCVD nitride film (sample D) showed little or no change. This confirms that H-R rich layer is effective in providing hydrogen to passivate surface states.

While the invention has been particularly shown and described witn reference to various embodiments, it will be recognized by those skilled in the art that modifications and changes may be made to the present invention without departing from the spirit and scope thereof. Merely by way of example, the H-R silicon layer can be used as a single film gate dielectric cap, a composite gate cap which comprises other films such as LPCVD nitride and/or various oxide films, gate conductor spacer film, as a final chip passivation material used alone or in combination with other dielectric materials, mobile ion and/or metallic contaminant barrier, or a contact etch stop. The scope of the invention should therefore be determined not with reference to the above description but with reference to the appended claims along with their full scope of equivalents.

## Claims

1. A process for fabricating a semi-conductor device comprising the steps of:
forming a layer of hydrogen-rich silicon nitride in the device; and
heating the device to a temperature above the temperature used for depositing the hydrogen rich silicon nitride layer, wherein the heating step causes hydrogen atoms to diffuse throughout the device for passivating surface states within the device.

2. The process as claimed in claim 1, wherein said device is a transistor comprising a gate region, a source region, and a drain region.

3. The process as claimed in claim 2, wherein said hydrogen-rich layer is formed over said gate, source, and drain regions.

4. The process as claimed in any preceding claim, wherein a layer of hydrogen-rich silicon nitride is formed within the structure of the device.

5. A process as claimed in any preceding claim, wherein a layer of hydrogen-rich silicon nitride is formed over the surface of the device.

6. The process as claimed in any preceding claim, wherein the step of forming said hydrogen-rich silicon nitride comprises plasma-enhanced chemical vapor deposition (PECVD).

7. The process as claimed in any preceding claim, wherein said hydrogen-rich silicon nitride comprises an amount of hydrogen greater than about 5 atomic weight percent.

8. The process as claimed in any preceding claim, wherein said hydrogen-rich silicon nitride comprises an amount of hydrogen greater than about 5 and less than or equal to about 39 atomic weight percent of hydrogen.

9. In device fabrication, a process for facilitating passivation of surface states in a device comprising the steps of:
forming a layer of hydrogen-rich silicon nitride in the device; and
heating the device to a temperature above the temperature used for depositing the hydrogen rich silicon nitride layer, wherein the heating step causes hydrogen atoms to diffuse throughout the device for passivating surface states within the device.
